# EUROPEAN PATENT APPLICATION

(11) **EP 4 510 179 A1**
(43) Date of publication of application: **19.02.2025**
(21) Application number: 23191961.4
(22) Date of filing: 17.08.2023
(51) Int. Cl.: H01L 23/00, H01L 23/29, H01L 23/373, H01L 23/31

(54) **APPLICATION OF A PROTECTIVE ALD OR PECVD LAYER ON A SEMICONDUCTOR DIE CONNECTED TO A SUBSTRATE VIA A SINTERED LAYER**

(71) Applicant: Infineon Technologies Austria AG, 9500 Villach (AT)
(72) Inventor: OTTO, Frederik, 59399 Olfen (DE); MIKUTTA, Lukas, 59609 Anröchte (DE); SAX, Harry, 94315 Straubing (DE); WEINHART, Michael, 92269 Fensterbach (DE)
(74) Representative: Lambsdorff & Lange Patentanwälte Partnerschaft mbB

(57) **Abstract**

A method for fabricating a semiconductor device, the method comprising providing a substrate, applying a sinter paste layer to the substrate, placing a semiconductor die on or above the sinter paste layer, performing a sintering process to convert the sinter paste layer to a sintered layer, and applying a protective layer by atomic layer deposition or by plasma-enhanced chemical layer deposition onto the semiconductor die and the sintered layer.

## Description

### TECHNICAL FIELD

The present disclosure is related to a method for fabricating a semiconductor device by connecting a semiconductor die to a substrate via a sintered layer and applying a protective layer onto the semiconductor die and a portion of the sintered layer by atomic layer deposition, and a semiconductor device.

### BACKGROUND

Electronic devices, for example power electronic devices, may comprise a semiconductor die or semiconductor chip which is attached to a chip pad of a substrate, for example a DCB (direct copper bond), an AMB (active metal brazed) or a leadframe. One example of a joining technique that is used to attach the die to the pad comprises sintering, wherein a paste layer is arranged between the die and the pad and pressure and/or temperature is applied to fabricate a sintered metal layer out of the paste layer.

However, experience with such sintered semiconductor die-substrate compounds has shown that corrosion problems can occur. In particular the following two types of corrosion in the die backside metallization stack are known throughout the industry to lead to significant technical problems when being exposed to humidity at elevated temperatures. In particular two types of corrosion are known which have in common that they are related to a degradation of metallic layers / interfaces in the chip backside metallization stack. The first type of corrosion is a halide-induced corrosion of individual layers in the backside metallization, for example, an aluminium layer. The second type of corrosion is an oxidative corrosion at interfaces between the individual layers of the chip backside metallization stack, for example, at the NiV/Ag or Ni/Ag or NiSi/Ag interface which is caused by oxygen diffusing through the sinter layer and the lowermost Ag layer of the backside metallization stack. Both these corrosion problems can weaken and/or ultimately destroy the interconnect.

For these and other reasons there is a need for the present disclosure.

### SUMMARY

Due to ever-increasing demands for higher operating temperatures of power modules, in particular in automotive applications, new packaging technologies are currently being introduced by virtually all power module manufacturers. One central technology is the so-called low-temperature joining technique (LTJT), which is commonly referred to as silver sintering. An example of silver sintering as a die attach technology is explained in the following. In short, a fine silver powder (which is usually provided in paste form) is placed between the two parts to be joined, these parts would be, for example, a die and a DCB (direct copper bond) or an AMB (active metal brazed) substrate. The whole assembly is then heated up to temperatures between 200 and 300°C, preferably but not necessarily under an externally applied pressure, e.g. in a press at a pressure in a range from 5 to 30 MPa and for a time duration in a range from 1 to 60 min. Under these conditions, the fine silver particles begin to sinter, i.e. they "grow together" or sinter to form a fairly compact silver layer by diffusional mechanisms. Since this layer consists of virtually pure silver (Ag) it possesses a melting point of 961°C which is much higher than that of soldered interconnects. This is one major factor why silver-sintered interconnects have superior properties compared to soldered ones when operated at elevated temperatures (e.g., T >= 1 7 5 ° C) .

The above-described procedure can also be performed using fine particles made from metals other than Ag, for example, Cu or noble metal powders or mixtures thereof. The present disclosure is independent of the nature of the particulate metal that is used for fabricating the sintered interconnect. As a consequence, it will be continued here to use only the term silver sintering, but will imply that Cu or other sinter materials will benefit to the certain extent.

There are two major aspects in which sintered joining layers differ fundamentally from soldered joints: the first is related to the microstructures of sinter layers (irrespective of the material from which they are made, e.g., Ag, Cu etc.) whereas the second applies specifically to sintered layers made from Ag. Both are described in the following.

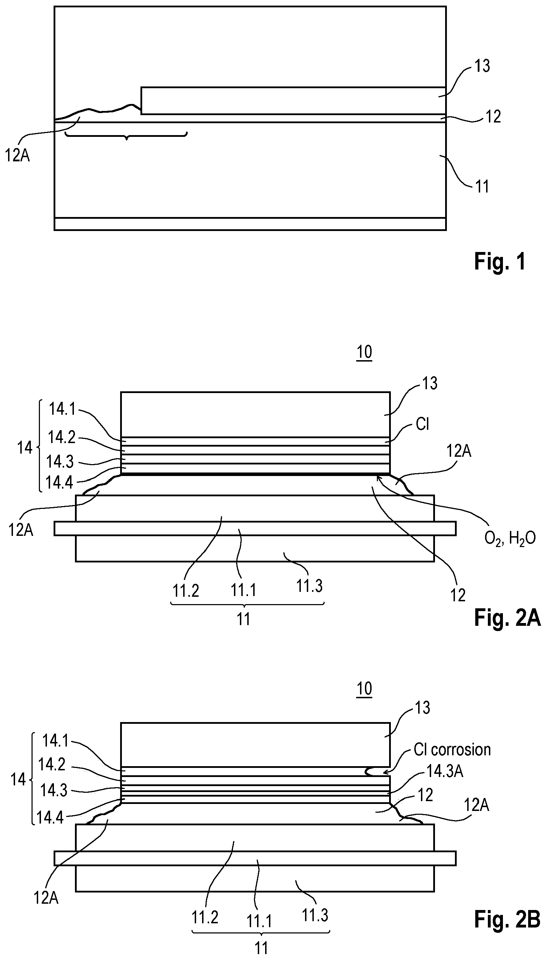

Fig. 1 shows a metallographic cross-section of a semiconductor die 13 attached to a copper substrate 11 by means of a sintered silver layer 12. Depending on the exact nature of the processes involved to fabricate this sintered layer 12 there is usually a certain degree of open porosity close to the edge of the semiconductor die 13 (exemplified by the brace in Fig. 1). In this context the word "open" means that an interconnected network of pores exists which has a connection to the outside. The region encompasses a bulge portion 12A of the sinter layer 12 not covering the semiconductor die 13, but usually also extends laterally under the semiconductor die 13. The extent of the region of open porosity near the semiconductor die 13 strongly depends on the exact nature and conditions of the processes used for fabricating the sintered layer 12, but is, in principle, always present to a certain degree. In addition to this microstructural porosity, sinter layers made from silver possess another type of permeability. It is well-known that silver becomes highly permeable to oxygen at elevated temperatures. That is, oxygen can readily diffuse through bulk silver even in the absence of an open pore network.

While the aforementioned aspects are generally not problematic from a mechanical / thermal / electrical standpoint, they facilitate certain corrosion mechanisms in the sinter joint. First of all, the regions close to the edges of the dies, i.e. those with an open porosity, can trap substances during further processing of the sintered die-substrate arrangement. In the simplest form this could be water, but it could also be highly corrosive substances from subsequent chemical process steps. These entrapped substances can subsequently cause or facilitate corrosion in two ways:
1) The entrapped substances directly corrode the sinter layer material and the die or substrate surfaces to which the sinter layer is attached.
2) The entrapped substances can gradually leave the porosity in the sinter layer and subsequently affecting the sidewall of the semiconductor die or other susceptible areas adjacent the edge of the sintered joint.

However, trapping of corrosive substances cannot only occur during processing. Humidity and other corrosive substances can also be brought in during the operation of power device. As most capsulating materials are to some degree permeable to water corrosion, water can penetrate the capsulating material and progress into the open porosity of the sinter layer. The situation becomes worse in cases where the humidity carries additional substances which are corrosive, most prominently halogenides such as chlorine (Cl), or have the capability to alter the electrical behaviour of the dies, for example, alkaline metals such as potassium (K) or sodium (Na).

The second type of corrosion applies to sintered joints that comprise silver only. Most commonly, silver is present as the sinter material itself, but is also common to have a terminating silver layer on the die backside and / or the substrate surface to facilitate sintering. Due to the aforementioned permeability of silver for oxygen, oxygen can diffuse through all of these silver layers under typical processing temperatures, but also under conditions the power device might experience during operation. The oxygen can then corrode the material layers underneath the terminating silver metallization layers of the die and / or substrate.

The present disclosure provides a solution to the above-described problems, which solution is the fabrication of a protective layer which is able to successfully increase the robustness of semiconductor dies against corrosion / degradation due to moisture and / or corrosive / deleterious elements. The focus will be on sintered die-substrate arrangements as the failure mechanisms describe above are unique to these, as soldered die attach layers are generally dense and do not possess regions of open porosities. They also do not consist of pure silver and are therefore not permeable to oxygen at elevated temperatures.

A first aspect of the present disclosure is related to a method for fabricating a semiconductor device, the method comprising providing a substrate, providing a semiconductor die, applying a sinter paste layer on one or both of the substrate and the semiconductor die, placing a semiconductor die on the substrate, performing a sintering process to convert the sinter paste layer to a sintered layer, and applying a protective layer by atomic layer deposition (ALD) or by plasma-enhanced chemical vapor deposition (PECVD) onto the semiconductor die and a portion of the sintered layer.

According to an embodiment of the method of the first aspect, a sinter paste drying treatment can be performed after applying the sinter paste layer.

According to an embodiment of the method of the first aspect, the protective layer comprises an oxide layer, in particular a metal oxide layer like, for example, one or more of an Al2O3, ZrO, TiO, Ta2O5 layer, or HfO2 layer. Otherwise the oxide layer may also comprise a SiO layer.

According to an embodiment of the method of the first aspect, the protective layer comprises a sandwich structure comprising two or more layers of different materials stacked upon each other. In particular, the sandwich structure may comprise two or more layers of the aforementioned materials.

According to an embodiment of the method of the first aspect, the protective layer comprises a thickness in a range from 3 nm to 200 nm.

According to an embodiment of the method of the first aspect, applying the protective layer by atomic layer deposition is performed at a temperature in a temperature range between room temperature and 250°C.

According to an embodiment of the method of the first aspect, applying the protective layer by plasma-enhanced chemical vapor deposition is performed at a temperature in a temperature range between 200°C and 400°C.

According to an embodiment of the method of the first aspect, the semiconductor die comprises a backside metallization layer and wherein the sinter paste layer is applied to the backside metallization layer. The backside metallization layer may, for example, comprise a single layer or two or more layers in the form of a layer stack. The layer stack may, for example, comprise two or more layers of Al, Ti, NiV, and Ag, wherein the Al layer can be applied directly on the backside of the semiconductor die, and the Ag layer can be the lowermost layer directly in contact with the sintered layer.

According to an embodiment of the method of the first aspect, applying the sinter paste layer comprises one or more of a printing process, a dispensing process, or a process of transferring the paste from a film onto the substrate or the semiconductor die.

According to an embodiment of the method of the first aspect, wherein the sinter paste layer comprises silver particles embedded in a paste.

According to an embodiment of the method of the first aspect, the substrate is one or more of a baseplate, a direct copper bond (DCB), an active metal brazed (AMB), an insulated metal substrate (IMS), and a leadframe.

A second aspect of the present disclosure is related to a semiconductor device comprising a substrate, a sintered layer disposed on the substrate, a semiconductor die disposed on or above the sintered layer, and a protective layer applied by atomic layer deposition onto the semiconductor die and the sintered layer.

According to an embodiment of the semiconductor device of the second aspect, the protective layer comprises an oxide layer, in particular a metal oxide layer like, for example, one or more of an Al2O3, ZrO, TiO, Ta205, or HfO2 layer. Otherwise the oxide layer may also comprise a SiO layer.

According to an embodiment of the semiconductor device of the second aspect, the protective layer comprises a sandwich structure comprising two or more layers of different materials stacked upon each other. In particular, the sandwich structure may comprise two or more layers of the aforementioned materials.

According to an embodiment of the semiconductor device of the second aspect, the protective layer comprises a thickness in a range from 3 nm to 200 nm.

According to an embodiment of the semiconductor device of the second aspect, the semiconductor die comprises a backside metallization layer and the semiconductor die is disposed with the backside metallization on or above the sintered layer. The backside metallization layer may, for example, comprise single layer or two or more layers in the form of a layer stack. The layer stack may comprise two or more layers of Al, Ti, Ni, NiV, NiSi, and Ag, wherein the Al layer can be applied directly on the backside of the semiconductor die, and the Ag layer can be the lowermost layer being directly in contact with the sintered layer.

According to an embodiment of the semiconductor device of the second aspect, wherein the sinter paste layer comprises silver particles embedded in a paste.

According to an embodiment of the semiconductor device of the second aspect, the substrate is one or more of a baseplate, a direct copper bond (DCB), an active metal brazed (AMB), an insulated metal substrate (IMS), and a leadframe.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 as already described above shows a metallographic cross-section of a semiconductor die attached to a copper substrate by means of a sintered silver layer.
Fig. 2 comprises Fig. 2A and 2B and shows cross sectional side view representations of an example of a semiconductor device comprising a semiconductor die attached to a substrate via a sintered layer without using a protective layer (A), and the same semiconductor device after occurrence of corrosion damages (B).

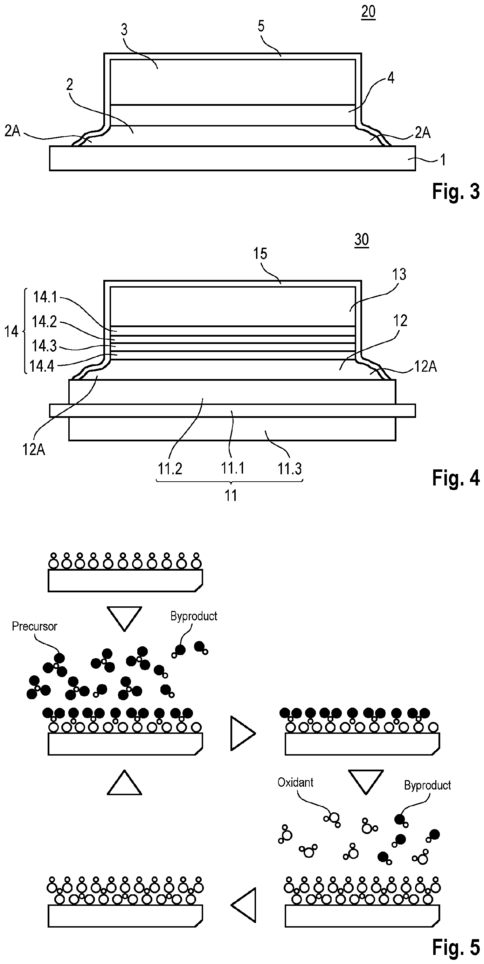

Fig. 3 shows a cross sectional side view representation of an example of a semiconductor device according to the second aspect, the semiconductor device comprising a semiconductor die attached to a substrate via a sintered layer and a protective layer covering the semiconductor die and portions of the sintered layer.
Fig. 4 shows a cross sectional side view representation of an example of a semiconductor device according to the second aspect, the semiconductor device corresponding to the example of a semiconductor device as shown in Fig. 2, this time with a protective layer covering the semiconductor die and portions of the sintered layer.
Fig. 5 shows schematic side views for illustrating one cycle of an atomic layer deposition process.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

Fig. 2 comprises Fig. 2A and 2B and shows cross sectional side view representations of an example of a semiconductor device comprising a semiconductor die attached to a substrate via a sintered layer without using a protective layer (A), and the same semiconductor device after occurrence of corrosion damages (B).

More specifically, Fig. 2A shows a semiconductor device 10 comprising a substrate 11, a sintered layer 12 applied to the substrate 11, a semiconductor die 13 disposed above the sintered layer 12. The substrate 11 is a direct copper bond comprising a center ceramic layer 11.1, an upper metallic layer 11.2, and a lower metallic layer 11.2. A backside metallization 14 is disposed on the backside of the semiconductor die 13, the backside metallization comprising an Al layer 14.1, a Ti layer 14.2, a NiV layer 14.3, and an Ag layer 14.4, in this order starting from the backside of the semiconductor die 13.

The semiconductor die 13 can be a semiconductor power transistor die like, for example, an IGBT, MOSFET, SiC-MOS or CoolMOS. Here, the term "power semiconductor transistor die" may refer to a semiconductor die providing at least one of high voltage blocking or high current-carrying capabilities. A power semiconductor die may be configured for high currents having a maximum current value of a few Amperes, such as e.g. 10 A, 250A, 600A, 1000A, or a maximum current value of up to or even exceeding 1000 A. Similarly, voltages associated with such current values may have values of a few Volts to a few tens or hundreds or even thousands of Volts.

Fig. 2B shows the same semiconductor device 10, but this time with additional arrows drawn in to illustrate the damaging effects of foreign substances entering the device. Thus, the upper arrow shows that penetrating chlorine can lead to a decomposition of the Al layer 14.1, as illustrated by the recess created thereby in the Al layer 14.1, while the lower arrow shows an undesired formation of a NiV oxide layer 14.3A below the NiV layer 14.3 due to the penetration of oxygen or water.

The sinter paste layer applied before the sintering process is carried out has silver particles embedded in a paste, which are baked together by the sintering process under the action of pressure and/or temperature to form a continuous electrically conductive layer. However, the sintering process also causes sintering material to flow out at the side edges and form relatively highly porous lateral bulges 12A as was already explained before. Due to their porosity and the porosity also present in the edge area of the sintered layer 12, the undesired penetration of foreign substances is favoured. Instead silver also metals can be used like, for example, copper or noble metal powders or mixtures thereof.

Fig. 3 shows a cross sectional side view representation of an example of a semiconductor device according to the second aspect, the semiconductor device comprising a semiconductor die attached to a substrate via a sintered layer and a protective layer covering the semiconductor die and portions of the sintered layer.

More specifically, Fig. 3 shows a semiconductor device 20 comprising a substrate 1, a sintered layer 2 applied to the substrate 1, and a semiconductor die 3 disposed above the sintered layer 2. The sintered layer also comprises bulges 2A as were shown in Fig. 2. A backside metallization 4 is disposed on the backside of the semiconductor die 3. The backside metallization 4 can be a single layer or two or more layers in the form of a layer stack. An example of the latter will be shown and explained in connection with Fig. 4. The substrate 1 can be one or more of a baseplate, a direct copper bond (DCB), an active metal brazed (AMB), an insulated metal substrate (IMS), and a leadframe.

A protective layer 5 is additionally applied to the upper and side surfaces of the semiconductor die 3, the side surfaces of the backside metallization 4 and portions of the sintered layer 2 and the bulges 2A to protect the entire assembly from directly interacting with undesirable substances. This protective layer 5 can be deposited by atomic layer deposition and may, for example, comprise Al2O3.

Fig. 4 shows a cross sectional side view representation of an example of a semiconductor device according to the second aspect, the semiconductor device corresponding to the example of a semiconductor device as shown in Fig. 2, this time with a protective layer covering the semiconductor die and portions of the sintered layer.

More specifically, Fig. 4 shows a semiconductor device 30 comprising a substrate 11, a sintered layer 12 applied to the substrate 11, a semiconductor die 13 disposed above the sintered layer 12. The substrate 11 is a direct copper bond comprising a center ceramic layer 12.1, an upper metallic layer 12.2, and a lower metallic layer 12.2. A backside metallization 14 is disposed on the backside of the semiconductor die 13, the backside metallization comprising an Al layer 14.1, a Ti layer 14.2, a NiV layer 14.3, and an Ag layer 14.4, in this order starting from the backside of the semiconductor die 13.

Insofar the semiconductor device 30 is still the same as the semiconductor device 10 of Figs. 1A, B. Now, however, a protective layer 15 is additionally applied to the upper and side surfaces of the semiconductor die 13, the side surfaces of the metallization layer stack 14 and portions of the sintered layer 12 and the bulges 12A to protect the entire assembly from penetration by undesirable substances. This protective layer 15 can be deposited by atomic layer deposition and may, for example, comprise Al2O3.

Fig. 5 shows schematic side views for illustrating one cycle of an atomic layer deposition process.

ALD relies on sequential, self-limiting surface reactions between gas phase precursor molecules and a solid surface, to obtain atomic layer control of the deposition, as shown schematically by the steps 1 to 4 in Fig. 5. The surface is first exposed to a precursor, which reacts with all of the initial surface sites. Then, after purging away the by-products from this first reaction, the surface is exposed to an oxidant. This reaction regenerates the initial functional groups and prepares the surface for the next exposure to the precursor. The film is grown to the desired thickness by repeating this sequence.

The initial situation is shown in the left-most sketch of Fig. 5, where a substrate is provided which is terminated by OH groups. Such a substrate is exposed to a pulse of trimethylaluminum vapor (TMA, typical exposure time of seconds) as the precursor (step 1). The TMA molecules adsorb on all exposed surfaces in the chamber and within pores, holes, and so on, in the sample. This deposition is self-limited, since the TMA molecules are chemisorbed through reaction with OH groups on the surface. Once all accessible OH groups have been consumed, no more TMA will adsorb (step 2). The TMA pulse is followed by an evacuation of the reaction chamber through purging or pumping, where after a pulse of the reactant, for example, water vapor is introduced (step 3). The water vapor reacts with the adsorbed TMA and hydrolyzes the residual methyl groups. This surface reaction results in the formation of a (sub)monolayer of alumina. Thereafter one notices the presence of OH groups terminating the first alumina layer (step 4). Therefore, the ALD process can be repeated over and over again to deposit films, one (usually fractional) atomic layer at a time.

As an alternative to the ALD process, the protective layer 5 or 15 can also be deposited using a plasma-enhanced chemical vapor deposition (PECVD) process. As is per se well known, PECVD is a chemical vapor deposition process used to deposit thin films from a gas state (vapor) to a solid state on a substrate. Chemical reactions are involved in the process, which occur after creation of a plasma of the reacting gases. The plasma is generally created by radio frequency (RF) (alternating current (AC) or direct current (DC) discharge between two electrodes, the space between which is filled with the reacting gases. For depositing Al2O3, for example, the used process gases N2O and Al(CH3)3 need to be dissociated and need to rearrange to form Al2O§ and other molecules. As compared to the ALD films, normally the mass density of the PECVD Al2O3 film is significantly lower.

### EXAMPLES

In the following specific examples of the present disclosure are described.

Example 1 is a method for fabricating a semiconductor device, the method comprising providing a substrate, providing a semiconductor die, applying a sinter paste layer on one or both of the substrate and the semiconductor die, placing the semiconductor die on the substrate, performing a sintering process to convert the sinter paste layer to a sintered layer, and applying a protective layer by atomic layer deposition or by plasma-enhanced chemical vapor deposition onto the semiconductor die and a portion of the sintered layer.

Example 2 is the method according to Example 1, further comprising a sinter paste drying treatment after applying the sinter paste layer.

Example 3 is the method according to Example 1 or 2, wherein the protective layer comprises an oxide layer.

Example 4 is the method according to Example 3, wherein the protective layer comprises a metal oxide layer.

Example 5 is the method according to Example 4, wherein the protective layer comprises one or more of Al2O3, ZrO, TiO, or Ta2O5.

Example 6 is the method according to Example 3, wherein the protective layer comprises SiO.

Example 7 is the method according to any one of the preceding Examples, wherein the protective layer comprises a sandwich structure comprising two or more layers of different materials stacked upon each other.

Example 8 is the method according to any one of the preceding Examples, wherein the protective layer comprises a thickness in a range between 3 nm and 200 nm.

Example 9 is the method according to any one of the preceding Examples, wherein the semiconductor die comprises a backside metallization layer and wherein the sinter paste layer is applied to the backside metallization layer.

Example 10 is the method according to any one of the preceding Examples, wherein applying the sinter paste layer comprises a printing process.

Example 11 is the method according to any one of Examples 1 to 9, wherein applying the sinter paste layer comprises transferring the paste from a film onto the substrate.

Example 12 is a semiconductor device comprising a substrate, a sintered layer disposed on the substrate, a semiconductor die disposed on or above the sintered layer, and a protective layer applied by atomic layer deposition or by plasma-enhanced chemical vapour deposition onto the semiconductor die and the sintered layer.

Example 13 is the semiconductor device according to Example 12, wherein the protective layer comprises an oxide layer.

Example 14 is the semiconductor device according to Example 13, wherein the protective layer comprises a metal oxide layer.

Example 15 is the semiconductor device according to Example 14, wherein the protective layer comprises one or more of Al2O3, ZrO, TiO, Ta2O5, or HfO2.

Example 16 is the semiconductor device according to Example 13, wherein the protective layer comprises SiO.

Example 17 is the semiconductor device according to any one of Examples 12 to 16, wherein the protective layer comprises a single layer or a sandwich structure comprising two or more layers of different materials stacked upon each other.

Example 18 is the semiconductor device according to any one of Examples 12 to 17, wherein the protective layer comprises a thickness in a range between 3 nm and 200 nm.

Example 19 is the semiconductor device according to any one of Examples 11 to 18, wherein the semiconductor die comprises a backside metallization layer and the semiconductor die is disposed with the backside metallization layer on or above the sintered layer.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method for fabricating a semiconductor device, the method comprising:
- providing a substrate;
- providing a semiconductor die;
- applying a sinter paste layer on one or both of the substrate and the semiconductor die;
- placing the semiconductor die on the substrate;
- performing a sintering process to convert the sinter paste layer to a sintered layer; and
- applying a protective layer by atomic layer deposition or by plasma-enhanced chemical vapor deposition onto the semiconductor die and a portion of the sintered layer.

2. The method according to claim 1, further comprising
a sinter paste drying treatment after applying the sinter paste layer.

3. The method according to claim 1 or 2, wherein
the protective layer comprises an oxide layer.

4. The method according to claim 3, wherein
the protective layer comprises a metal oxide layer.

5. The method according to claim 4, wherein
the protective layer comprises one or more of Al2O3, ZrO, TiO, or Ta2O5.

6. The method according to claim 3, wherein
the protective layer comprises SiO.

7. The method according to any one of the preceding claims, wherein
the protective layer comprises a sandwich structure comprising two or more layers of different materials stacked upon each other.

8. The method according to any one of the preceding claims, wherein
the protective layer comprises a thickness in a range between 3 nm and 200 nm.

9. The method according to any one of the preceding claims, wherein
the semiconductor die comprises a backside metallization layer and wherein the sinter paste layer is applied to the backside metallization layer.

10. The method according to any one of the preceding claims, wherein
applying the sinter paste layer comprises a printing process.

11. The method according to any one of claims 1 to 9, wherein applying the sinter paste layer comprises transferring the paste from a film onto the substrate.

12. A semiconductor device (20; 30) comprising:
- a substrate (1; 11);
- a sintered layer (2; 12) disposed on the substrate (1; 11);
- a semiconductor die (3; 13) disposed on or above the sintered layer (2; 12); and
- a protective layer (5; 15) applied by atomic layer deposition or by plasma-enhanced chemical vapour deposition onto the semiconductor die (3; 13) and the sintered layer (2; 12).

13. The semiconductor device (20; 30) according to claim 12, wherein
the protective layer (5; 15) comprises an oxide layer.

14. The semiconductor device (20; 30) according to claim 13, wherein
the protective layer (5; 15) comprises a metal oxide layer.

15. The semiconductor device (20; 30) according to claim 14, wherein
the protective layer (5; 15) comprises one or more of Al2O3, ZrO, TiO, Ta2O5, or HfO2.

16. The semiconductor device (20; 30) according to claim 13, wherein
the protective layer (5; 15) comprises SiO.

17. The semiconductor device (20; 30) according to any one of claims 12 to 16, wherein
the protective layer (5; 15) comprises a single layer or a sandwich structure comprising two or more layers of different materials stacked upon each other.

18. The semiconductor device (20; 30) according to any one of claims 12 to 17, wherein
the protective layer (5; 15) comprises a thickness in a range between 3 nm and 200 nm.

19. The semiconductor device (20; 30) according to any one of claims 11 to 18, wherein
the semiconductor die (3; 13) comprises a backside metallization layer (4; 14) and the semiconductor die (3; 13) is disposed with the backside metallization layer (4; 14) on or above the sintered layer (2; 12).
